# EUROPÄISCHE PATENTSCHRIFT

(11) **EP 1 840 926 B1**
(45) Veröffentlichungstag und Bekanntmachung des Hinweises auf die Patenterteilung: **19.10.2011**
(21) Anmeldenummer: 06111910.3
(22) Anmeldetag: 29.03.2006
(51) Int. Cl.: H01J 1/88, H01J 37/32

(54) **Isolierende Vakuumdrehdurchführung für Rotationsmagnetrons**
Isolating vacuum feedthrough for rotatable magnetrons
Joint tournant isolant d'un magnétron rotatif

(43) Veröffentlichungstag der Anmeldung: 03.10.2007
(73) Patentinhaber: Applied Materials GmbH & Co. KG, 63755 Alzenau (DE)
(72) Erfinder: Dr. Trassl, Roland, 35392, Gießen (DE); Sauer, Andreas, 63762, Großostheim (DE); Gärtner, Harald, 61137, Schöneck (DE)
(74) Vertreter: Lang, Christian

(56) Entgegenhaltungen:
- US-A1- 2006 049 043
- US-B1- 6 365 010

## Beschreibung

### Technisches Gebiet

Die vorliegende Erfindung betrifft eine Kathodenanordnung nach dem Oberbegriff des Anspruchs 1, insbesondere eine Vakuumdrehdurchführung für Rotationsmagnetrons.

### Stand der Technik

Rotationsmagnetrons oder allgemein rotierbare Kathoden bzw. Targets sind für Beschichtungszwecke mittels Sputtern bekannt. Bei derartigen drehbaren Kathoden bzw. Magnetrons (rotatable magnetrons) wird eine zylinderförmige Kathode bzw. ein entsprechendes Target während des Sputterprozesses gedreht, wobei die Magnetanordnung im Inneren der zylinderförmigen Kathode bzw. Target angeordnet ist. Ein Beispiel hierfür ist in der US 2002/0189939 A1 gegeben.

Da derartige Beschichtungsprozesse bzw. Sputter-Prozesse unter Vakuum ablaufen, müssen Vorrichtungen und Anordnungen bereitgestellt werden, die eine Durchführung einer drehbaren Welle durch eine Vakuumkammerwand unter Aufrechterhaltung der Vakuumbedingungen in der Vakuumkammer ermöglichen. Derartige Vakuumdrehdurchführungen weisen nach dem Stand der Technik, beispielsweise der US 2002/0189939 so genannte Ferrofluid-Dichtungen auf, bei denen eine kolloidale Suspension von ultramikroskopischen Partikeln in einem flüssigen Träger aufgenommen sind und durch eine Magnetanordnung in einem abzudichtenden Spalt gehalten werden.

Darüber hinaus kommen auch einfache O-Ringe als Dichtungen zum Einsatz, wie beispielsweise in der US 6,365,010 B1 beschrieben ist, wobei jedoch nach dem Stand der Technik Ferrofluid-Dichtungen bevorzugt sind.

Aus der US 5,518,592 ist zudem eine Vakuumdrehdurchführung bekannt, bei der eine äussere und eine innere Hülle einer Vakuumdrehdurchführung beabstandet zueinander angeordnet sind und zwischen sich Lager- und Dichtmittel aufnehmen.Weitere Drehdurchführung sind aus der US 2006/049043 A1 oder der WO 2006/020582 bekannt, wobei insbesondere die WO 2006/020582 eine komplexe Anordnung von über entsprechende Lager beanstandet zueinander angeordneten drehbaren und ortsfesten Teilen offenbart, wobei durch die zusätzlichen Bauteile, wie entsprechende Drehlager, zusätzliche Fehlerquellen eingebracht werden.

Obwohl mit diesen Dichtungen zum Teil ganz gute Erfahrungen gemacht worden sind, hat sich gezeigt, dass insbesondere bei einem Betrieb derartiger drehbarer Kathoden im mittel- bis hochfrequenten Bereich mit Wechselspannungen bzw. -strömen Kein Dauerbetrieb der Anlagen # gewährleistet werden kann, da insbesondere bei hohen Leistungen ein Ausfall der Dichtungen zu beobachten ist.

### Offenbarung der Erfindung

### Technische Aufgabe

Es ist deshalb Aufgabe der vorliegenden Erfindung, die Nachteile des Standes der Technik zu überwinden und insbesondere für Einsätze bei hoch- bis mittelfrequente Wechselspannungen oder -strömen mit hohen Leistungen eine Kathodenanordnung mit einer drehbaren Kathode bereit zu stellen, bei welcher ein Dauerbetrieb gewährleistet ist. Ferner soll die Anordnung einfach zu montieren, robust und kostengünstig sein.

### Technische Lösung

Die oben genannte Aufgabe wird gelöst durch eine Kathodenanordnung mit den Merkmalen des Anspruchs 1. Vorteilhaft Ausgestaltungen sind Gegenstand der abhängigen Ansprüche.

Die vorliegende Erfindung geht aus von der Erkenntnis der Erfinder, dass die mangelnde Lebensdauer der Dichtungen bei bei mittel- bis hochfrequenten Wechselspannungen bzw. -strömen betriebenen Kathodenanordnungen damit zusammenhängen, dass bei Ferrofluid-Dichtungen es zu einer Einkopplung der mittel- bis hochfrequenten elektromagnetischen Wellen in die Ferrofluid-Dichtungen kommt und somit Wirbelströme induziert werden, die die Dichtung aufheizen. Gleiches gilt für Dichtungen, die beispielsweise in metallischen Einsätzen angeordnet sind. Außerdem führen gerade bei Ferrofluid-Dichtungen kleine Potenzialdifferenzen an den Spalten, an denen die Ferrofluid-Flüssigkeit vorgesehen ist, zu Feldstärken, die zu Lichtbogen-Entladungen führen und somit zu einer Zerstörung der Dichtung führen können. Entsprechend haben die Erfinder erkannt, dass es wesentlich ist, eine Vakuum-Drehdurchführung bereit zu stellen, die im Wesentlichen auf elektrisch leitfähige und insbesondere metallische Bestandteile verzichtet. Erfindungsgemäß ist somit ein Einsatz zwischen einem drehbaren Teil einer drehbaren Kathode bzw. eines Targets und einem oder mehreren umgebenden festen Bauteilen vorgesehen, welcher als Isolator ausgeführt ist und insbesondere aus einem Kunststoff besteht, der für den Vakuumeinsatz geeignet ist. Hierbei bieten sich insbesondere Polyetheretherketone (PEEK), Polyoxymethylen bzw. Polyacetal (POM) oder Polyethylenteraphthalat (PET) an. Durch die Verwendung eines Isolators als Einsatz zwischen dem drehbaren Teil der Magnetronkathode und dem oder den aufnehmenden bzw. umgebenden feststehenden Bauteilen wird eine Einkopplung von Wirbelströmen vermieden und somit ist eine geschützte Anordnung von Dichtungen durch den Einsatz möglich.

Der Einsatz kann sowohl drehfest an dem drehbaren Teil der Kathode oder drehfest an dem oder den umgebenden feststehenden Bauteilen angeordnet sein, so dass der Einsatz entweder selbst ortsfest ist oder mit der drehbaren Kathode dreht.

Der Einsatz kann ein- oder mehrteilig ausgebildet sein und weist grundsätzlich eine im wesentlichen zylinderrohrartige Form auf, so dass das drehbare Teil der Kathode, insbesondere eine entsprechende Antriebswelle oder dergleichen von dem Einsatz umgeben ist. Darüber hinaus kann der Einsatz vorzugsweise an einem Ende, beispielsweise dem der Vakuumkammer zugeordneten Ende einen flanschartigen Ansatz aufweisen, so dass dieser gegenüber dem oder den feststehenden Bauteilen, wie beispielsweise einer Vakuumkammerwand oder einer Gehäusewand einer Antriebseinheit für den drehbaren Antrieb der drehbaren Kathode nicht nur Anlage- bzw. Dichtflächen parallel zur Drehachse des drehbaren Teils aufweist, sondern auch quer dazu bzw. insbesondere senkrecht dazu. Dies hat den Vorteil, dass entsprechende Dichtungen in den Anlage- bzw. Dichtflächen nicht nur in radialer Richtung wirken können sondern auch in axialer Richtung, was den Einbau des Einsatzes deutlich vereinfacht und zudem verhindert, dass es während des Einbaus zu einer Schädigung der Dichtungen kommen kann.

Dem Einsatz ist eine gegenüberliegende Gegenlauffläche zugeordnet, die gegenüberliegend der Innenseite des Einsatzes vorgesehen ist. Einsatz und Gegenlauffläche drehen sich relativ zueinander, wenn die Kathode rotiert. Allerdings kann entweder der Einsatz ortsfest gehalten sein oder die Gegenlauffläche. Erfindungsgemäß weisen Einsatz und Gegenlauffläche mindestens eine gegenseitig gegeneinander anliegende Dicht- und Lauffläche auf, zu welcher auch entsprechende Dichtungen vorgesehen sind.

Die Gegenlauffläche kann als separates Bauteil ausgeführt sein oder in dem drehbaren Teil, also beispielsweise der Antriebswelle, oder in den oder dem umgebenden feststehenden Bauteilen, wie einer Gehäusewand, integriert sein.

Die Gegenlauffläche ist vorzugsweise mit ihren Gleit- und/oder Dichtflächen auf den Einsatz und/oder dazwischen angeordnete Dichtungen angepasst, so dass eine optimale Gleitung und Dichtung erzielt werden kann, ohne dass es zu unerwünschtem Abrieb kommt.

Zwischen der Gegenlauffläche und dem Einsatz sind ein oder mehrere dynamische Dichtungen angeordnet, die während der relativen Drehbewegung zwischen Einsatz und Gegenlauffläche eine Dichtwirkung bereitstellen. Dynamische Dichtung bedeutet somit, dass hier eine Dichtung unter einer Relativbewegung stattfindet, während von statischer Dichtung dann gesprochen wird, wenn die gegenseitig abzudichtenden Bauteile sich gegeneinander nicht bewegen.

Der Einsatz weist vorzugsweise auf einer seiner Hauptseiten ein oder mehrere dynamische Dichtungen auf, d.h. beispielsweise an seiner Innenseite, während er an der gegenüberliegenden Hauptseite, beispielsweise an der Außenseite, eine oder mehrere statische Dichtungen aufweist bzw. diese ihm zugeordnet sind. Selbstverständlich kann die Anordnung der Dichtungen auch umgekehrt sein, so dass die dynamischen Dichtungen an der Außenseite vorgesehen sind, während die statischen Dichtungen an der Innenseite. In diesem Falle würde beispielsweise der Einsatz drehfest mit der Welle verbunden sein, so dass an der Innenseite die statischen Dichtungen gegenüber der Welle abdichten, während der Einsatz gegenüber den umgebenden, feststehenden Bauteilen oder einer daran angeordneten Gegenlauffläche rotiert und somit an der Außenfläche die dynamischen Dichtungen angeordnet bzw. dieser zugeordnet sind.

Vorzugsweise weist der Einsatz an der Seite, an der die dynamischen Dichtungen vorgesehen sind, mindestens einen, vorzugsweise mehrere umlaufende Kanäle auf, die insbesondere zwischen den Dichtungen vorgesehen sind, wobei die Kanäle zur Absaugung der Zwischenräume und/oder zur Einbringung von Schmiermitteln dienen, welche zur besseren Gleitung der dynamischen Dichtungen beitragen.

Sofern eine Gegenlauffläche als separates Bauteil vorgesehen ist, weist dieses Bauteil an der Seite, die dem Einsatz gegenüberliegt, eine oder mehrere statische Dichtungen auf oder ist dieser Seite zugeordnet, um eine Abdichtung gegenüber dem entsprechenden angrenzenden Bauteil zu erzielen.

Insgesamt können die Dichtungen, also sowohl die statischen Dichtungen als auch die dynamischen Dichtungen gegenüber Dichtflächen wirken, die parallel zur Drehachse oder quer, insbesondere senkrecht zur Drehachse ausgerichtet sind, so dass die Dichtungen in radialer und/oder axialer Richtung wirken. Insbesondere bei den statischen Dichtungen zwischen einem feststehenden Einsatz oder einer Gegenlauffläche einerseits und den umgebenden feststehenden Bauteilen andererseits kann es vorteilhaft sein, statische Dichtungen in axialer Wirkrichtung vorzusehen, da diese den Einbau erleichtern und die Schonung der Dichtungen beim Einbau ermöglichen.

Insbesondere kann es vorteilhaft sein, den Einsatz, der eine im wesentlichen zylinderrohrförmige Grundgestalt aufweist, mit einem flanschartigen Ansatz bzw. Fortsatz zu versehen, so dass in axialer Richtung Dichtflächen entstehen, um dort axial wirkende Dichtungen unterzubringen. Dies ermöglicht beispielsweise einen besonders einfachen Einbau des Einsatzes, auch von der Vakuumkammerseite aus.

Die dynamischen und statischen Dichtungen, die vorgesehen werden können, umfassen O-Ringe, X-Ringe, Dichtlippenkörper unterschiedlichster Gestalt sowie sonstige Dichtkörper, die insbesondere ringförmig vorgesehen sind.

Die Dichtungen sind vorzugsweise in Nuten oder nutartigen Ausnehmungen angeordnet, die ringförmig umlaufend sowohl an dem Einsatz, an der dem Einsatz zugeordneten Gegenlauffläche, dem oder den umgebenden feststehenden Bauteilen und/oder den drehbaren Teilen vorgesehen sein können. Vorzugsweise sind die Dichtungen jedoch in dem isolierenden Einsatz vorgesehen.

Die Dichtungen und insbesondere die dynamischen Dichtungen sind aus Polytetraflurethylen (Teflon), Gummi, sonstigen Elastomeren oder Verbundwerkstoffen mit Graphit- oder Kohlefaser gebildet oder umfassen diese und weisen vorzugsweise Gleitbeschichtungen auf. Die Gegenlauffläche und insbesondere ihre Oberfläche werden vorzugsweise aus gehärtetem Stahl, diamantartigen Kohlenstoffschichten, Chromoxydschichten oder anderen Gleitschichten gebildet.

Mit der beschriebenen Kathodenanordnung bzw. der dort eingesetzten Vakuumdrehdurchführung ist eine vakuumdichte Anordnung von drehbaren Kathoden bzw. Targets und insbesondere Magnetrons unter Aufrechterhaltung guter Vakuumbedingungen in einfacher Weise möglich, wobei gleichzeitig für den mittel- bis hochfrequenten Einsatz bei Wechselspannungen bzw. Wechselströmen mit hohen Leistungen eine gute Lebensdauer gewährleistet ist.

### Kurze Beschreibung der Zeichnungen

Weitere Vorteile, Kennzeichen und Merkmale der vorliegenden Erfindung werden bei der nachfolgenden detaillierten Beschreibung von bevorzugten Ausführungsbeispielen anhand der beigefügten Zeichnungen deutlich. Die Zeichnungen zeigen hierbei in rein schematischer Weise in

Fig.1 eine Schnittansicht einer Antriebseinheit für eine drehbare Magnetronkathode;

Fig.2 eine Schnittansicht einer Vakuumdrehdurchführung einer erfindungsgemäßen Kathodenanordung,

Fig.3 eine weitere Schnittansicht eines zweiten Ausführungsbeispiels einer Vakuumdrehdurchführung einer erfindungsgemäßen Kathodenanordung;

Fig.4 eine Schnittansicht eines dritten Ausführungsbeispiels einer Vakuumdrehdurchführung einer erfindungsgemäßen Kathodenanordung;

Fig.5 eine teilweise Schnittansicht einer Antriebseinheit für eine Magnetron-Rotationskatode mit einer vierten Ausführungsform der Vakuumdrehdurchführung einer erfindungsgemäßen Kathodenanordung.

### Ausführungsform(en) der Erfindung

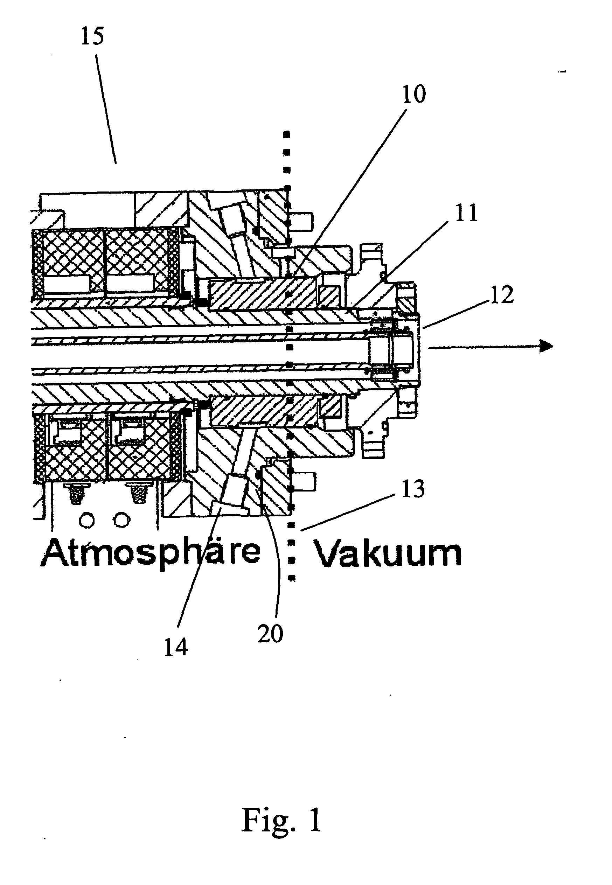

In Figur 1 ist eine Antriebseinheit 15 für eine drehbare Magnetron-Rotationskatode, so genannte Rotatable Magnetrons, gezeigt.

In dem Drehantrieb ist eine drehbare Welle 11 aufgenommen, an deren Ende ein Flansch 12 zur Anordnung einer Rotationskathode bzw. eines Targets vorgesehen ist. Mit 13 ist in einer punktierten Linie schematisch der Verlauf einer Vakuumkammerwand angedeutet, in welcher die Antriebseinheit 15 vakuumdicht eingebaut werden kann.

Die Antriebseinheit 15 weist eine Vakuumdrehdurchführung 10 für die Welle 11 auf, die in den nachfolgenden Figuren näher erläutert wird.

Oberhalb und unterhalb der drehbaren Welle 11 sind in der Schnittansicht der Fig. 1 Absaugleitungen 14 vorgesehen, die in die Vakuumdrehdurchführung münden und dort, wie später noch gezeigt werden wird, zur Absaugung mit der Vakuumdrehdurchführung 10 zusammen wirken. Um den zylinderförmigen Umfang der Antriebseinheit 15 bzw. der Vakuumdrehdurchführung 10 können mehrere dieser Absaugleitungen 14 beabstandet zueinander vorgesehen sein.

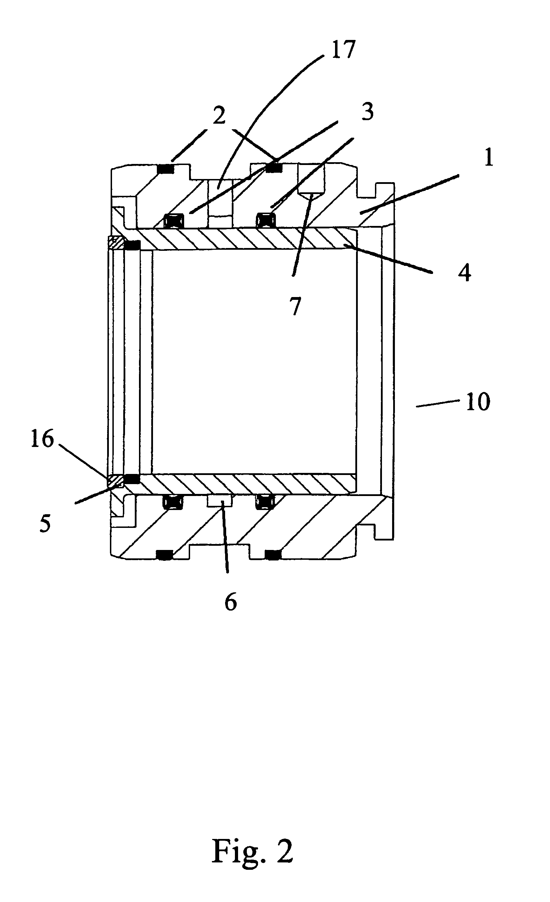

Die Figur 2 zeigt in einer Schnittansicht eine erste Ausführungsform einer Vakuumdrehdurchführung 10 einer erfindungsgemäßen Kathodenanordung, welche einen im Wesentlichen zylinderrohrförmigen Einsatz 1 aus einem Kunststoffmaterial, welches insbesondere für Vakuumbedingungen geeignet ist, aufweist. Hier bieten sich Kunststoffe aus dem Bereich Polyetheretherketon (PEEK) Polyoxymethylen bzw. Polyacetal (POM) oder Polyethylenterephthalat (PET) an, die sowohl gute Gleiteigenschaften, einen geringen Abrieb, Beständigkeit gegenüber Chemikalien und dergleichen aufweisen.

Der Einsatz 1 wird gemäß dem gezeigten Ausführungsbeispiel einer Vakuumdrehdurchführung einer erfindungsgemäßen Kathodenanordung an dem Gehäuse der Antriebseinheit 15 oder unmittelbar an einer Vakuumkammerwand (nicht gezeigt) mit einer Schraubverbindung fixiert, welche in das Sackloch 7 eingreift. Damit wird der Einsatz 1 ortsfest gehalten, wobei in radialer Richtung zwei statische Dichtungen 2 in Form von O-Ringen gegen eine Dichtfläche des feststehenden Bauteils in Form des Gehäuses der Antriebseinheit 15 oder der Vakuumkammerwand abdichten. Die Ringe 2 sind hierbei in Nuten des Einsatzes 1 aufgenommen.

Auf der Innenseite des zylinderrohrförmigen Einsatzes 1 sind ebenfalls zwei umlaufende Nuten vorgesehen, in denen dynamische Dichtungen 3 in Form von X-Ringen aufgenommen sind. Diese dichten gegenüber einem ebenfalls zylinderrohrförmigen Körper, bzw. dessen Dichtfläche ab, welcher die Gegentaufftqche 4 darstellt. Die Gegenlauffläche 4 ist in dem Ausführungsbeispiel einer Vakuumdrehdurchführung einer erfindungsgemäßen Kathodenanordung; der Figur 2 ein separates Bauteil, welches auf der Welle 11 oder in einer Aussparung der Welle 11 angeordnet wird. Beispielsweise kann dies durch Aufschrumpfen erfolgen. Zwischen der Gegenlauffläche 4 und der Welle 11 (nicht gezeigt) ist eine statische Dichtung 5 vorgesehen, die in dem gezeigten Ausführungsbeispiel einer Vakuumdrehdurchführung einer erfindungsgemäßen Kathodenanordung;der Figur 2 in einer Aussparung bzw. Schulter an einem Ende der Gegenlauffläche 4 durch eine Spannring 16 gehalten ist. An der Innenseite des Einsatzes 1 kann durch Vorsehen einer weiteren umlaufenden Nut ein Kanal 6 ausgebildet sein, der mittels einer Durchführung 17 mit der Absaugleitung 14 verbunden ist und dazu dient, die beiden dynamischen Dichtungen 3 zu überwachen. Durch eine Veränderung des Drucks, welcher mit einer Vorpumpe mit einem gegenüber den Pumpen der Prozesskammer geringerem Saugvermögen eingestellt wird, lässt sich ermitteln, welche der Dichtungen 3 defekt ist. Bei zunehmendem Druck verliert die Dichtung in Richtung der Atmosphärenseite an Wirkung, während bei niedrigerem Druck die Dichtung zur Prozesskammer nachlässt.

Mit dem gezeigten Ausführungsbeispiel derVakuumdrehdurchführung 10 einer Vakuumdrehdurchführung einer erfindungsgemäßen Kathodenanordung; wird deutlich, dass durch die Ausbildung des Einsatzes 1 aus einem isolierenden Kunststoff eine isolierende Vakuumdrehdurchführung gegeben ist, da soweit auf metallische Bauteile verzichtet werden kann, dass keine durchgehende metallische Verbindung gegeben ist. Außerdem wird vermieden, dass im Einsatz 1 Wirbelströme induziert werden.

Darüber hinaus wird durch das Vorsehen der Gegenlauffläche eine Anpassung der Gleit- und/oder Dichtflächen zwischen Einsatz 1 und Gegenlauffläche 4 bzw. den dynamischen Dichtungen 3 und der Gegenlauffläche 4 möglich. Die Gegenlauffläche 4 wird insbesondere an ihrer Außenseite, also der Dicht- und/oder Gleitfläche aus einem gehärtetem Stahl, hergestellt und/oder mit einer diamantartigen Kohlenstoffschicht (diamond like carbon DLC) oder einer Chromoxydschicht versehen.

Die dynamischen Gleitdichtungen in Form der X-Ringe können beispielsweise Ringe von Viton oder NBR mit oder ohne Gleitbeschichtung sein.

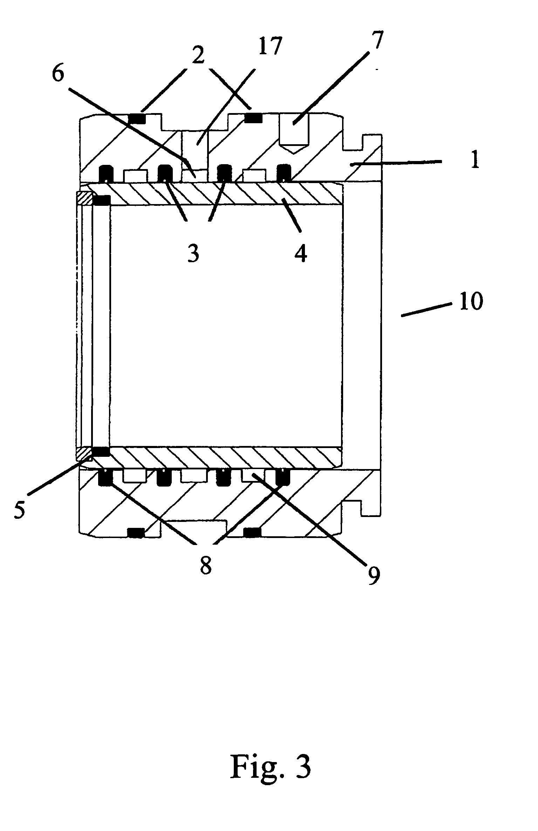

In Figur 3 ist ebenfalls in einer Schnittansicht eine weitere Ausführungsform einer Vakuumdrehdurchführung 10 einer erfindungsgemäßen Kathodenanordung; gezeigt, die im Grundaufbau der Ausführungsform der Figur 2 entspricht. Entsprechend sind ähnliche oder identische Bauteile mit identischen Bezugszeichen versehen.

Die Ausführungsform der Figur 3 unterscheidet sich neben einer geringfügigen konstruktiven Änderung bezüglich der Gegenlauffläche (kein flanschartiges Ende, linke Bildseite) im Wesentlichen dadurch, dass mehr dynamische Dichtungen 3 vorgesehen sind, und dass andere Dichtungselemente zum Einsatz kommen.

In dem Ausführungsbeispiel einer Vakuumdrehdurchführung einer erfindungsgemäßen Kathodenanordung; der Figur 3 sind insgesamt vier dynamische Dichtringe aus einem Polytetrafluorethylen (PTFE) -Material vorgesehen, wobei dieses Material ein Verbundwerkstoff beispielsweise aus PTFE mit Graphit bzw. mit Kohlefaser sein kann.

Zusätzlich zu dem umlaufenden Kanal 6 sind zwei weitere umlaufende nutartige Aussparungen 9 vorgesehen, die zur Aufnahme von Schmiermitteln in den Bereichen zwischen den dynamischen Dichtungen 3 dienen. Als Schmiermittel können hier insbesondere vakuumtaugliche Schmiermittel zum Einsatz kommen, welche die Gleiteigenschaften der Rotationsdichtungen 3, die zwischen den Aussparungen 9 bzw. benachbart zu diesen und dem Absaugkanal 6 angeordnet sind, dienen.

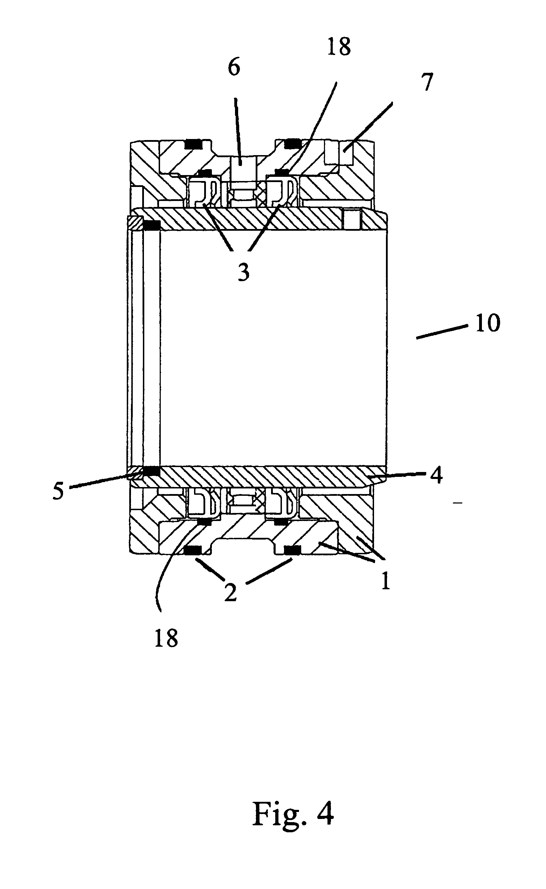

Die Figur 4 zeigt eine dritte Ausführungsform einer Vakuumdrehdurchführung einer erfindungsgemäßen Kathodenanordung; der der Einsatz 1 zweiteilig ausgebildet ist. Die zweiteilige Form des Einsatzes hat den Vorteil, dass die dynamischen Dichtelemente 3 in Form von Dichtlippenkörpem aus PTFE oder PTFE-Verbundwerkstoffen leicht in die entsprechenden Aufnahmeräume eingesetzt werden können, wobei die Grundgestalt des Einsatzes 1 in Form einer Zylinderrohrform durch die komplementären Teile des Einsatzes 1 weiterhin gegeben ist. Allerdings sind zur Ausbildung von geeigneten Dichtflächen zwischen den Dichtlippenkörpern 3 und dem Einsatz 1 an dem Einsatz 1 zusätzliche Dichtelemente 18 vorgesehen.

Im Übrigen entspricht die Ausführungsform der Figur 4 im Wesentlichen den Ausführungsformen der Figuren 2 und 3.

In den Beispielen der Figuren 2 bis 4 dreht sich die Gegenlauffläche 4 mit der Welle 11, während der isolierende Einsatz 1 ortsfest gehalten ist und radial nach außen mit den statischen Dichtungen 2 abdichtet.

Zwischen der Gegenlauffläche 4 und dem Einsatz 1 sind ringförmige Dichtkörper 3 umlaufend vorgesehen, die in den entsprechenden Aussparungen oder Nuten des Einsatzes 1 aufgenommen sind. Diese dynamischen Dichtungen 3 können als im Wesentlichen
ringförmige Dichtkörper 3 ausgeführt sein, die einen im Wesentlichen L-förmigen Querschnitt aufweisen.

Die Dichtelemente 3 können aus
Gummi, z. B. von Viton, aus PTFE, oder einem vergleichbaren Material mit oder ohne Gleitbeschichtungen gebildet sein.

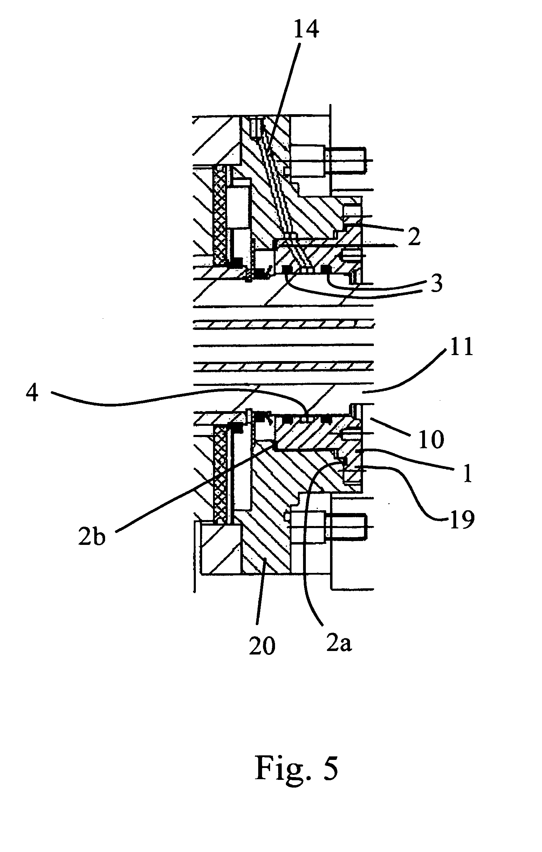

In Figur 5 ist eine Ausführungsform einer erfindungsgemäßen drehbaren Kathodenanordnung mit einer entsprechenden Vakuumdrehdurchführung 10 wiedergegeben. Bei dieser Anordnung weist der Einsatz 1 eine im Wesentlichen zylinderrohrförmige Gestalt mit einem Flanschfortsatz 19 auf, der es ermöglicht, eine erste statische Dichtung 2a gegenüber dem Gehäuse 20 nicht in radialer Wirkrichtung, sondern in axialer Wirkrichtung anzuordnen, d. h. die Dichtfläche ist nicht parallel zur Drehachse der Welle 11, sondern im Wesentlichen quer, insbesondere senkrecht dazu angeordnet. Dies ermöglicht einen insbesondere einfachen Einbau des Einsatzes 1 vorzugsweise auch von innerhalb der Vakuumkammer, ohne dass eine Beschädigung der statischen Dichtungen 2 zu befürchten ist.

Eine zweite statische Dichtung 2b, ebenfalls in axialer Wirkrichtung, d. h. in einer senkrecht zur Drehachse angeordneten Dichtfläche ist an der Stirnseite des Einsatzes 1 vorgesehen.

Darüber hinaus zeigt die Ausführungsform der Figur 5, dass die Gegenlauffläche 4 integral in der Welle 11 vorgesehen sein kann, ohne dass es zur Ausbildung eines separaten Bauteils kommen muss. Die dynamischen Dichtungen 3, die nach jeder der vorher beschriebenen Arten gebildet sein können, dichten somit direkt gegenüber der Welle 11 ab.

In den Figuren 1 bis 5 ist jeweils die Vakuumdrehdurchführung 10 so aufgebaut, dass der Einsatz 1 drehfest in dem Gehäuse 20 einer Antriebseinheit 15 bzw. einer Vakuumkammerwand angeordnet ist, während die Gegenlauffläche 4 mit der drehbaren Welle 11 dreht bzw. in dieser integriert ist. Selbstverständlich ist es jedoch auch denkbar, dass der Einsatz 1 drehfest an der Welle 11 angeordnet ist und somit mit dieser dreht, während die Gegenlauffläche 4 ortsfest in dem Gehäuse 20 oder der Vakuumkammerwand angeordnet ist. Darüber hinaus ist es auch denkbar, dass die Gegenlauffläche 4 in dem Gehäuse 20 oder in der Vakuumkammerwand integriert ist.

Darüber hinaus wurden sowohl die statischen Dichtungen 2 als auch die dynamischen Dichtungen 3 jeweils in nutartigen Aussparungen des Einsatzes 1 aufgenommen. Es ist jedoch auch denkbar, dass die Dichtungen 2, 3 in nutartigen Aussparungen der Gegenlauffläche 4, des Gehäuses 20 oder eines anderen feststehenden Bauteils wie der Vakuumkammerwand, oder der Welle 11 aufgenommen sind.

## Patentansprüche

1. Kathodenanordnung mit einer drehbaren Kathode, mindestens einem feststehenden Bauteil, einem Einsatz (1) und einer Gegenlauffläche, (4) wobei zumindest ein Teil der Kathode drehbar und vakuumdicht in dem zumindest einen feststehenden Bauteil angeordnet ist und der Einsatz (1) zwischen dem drehbaren Teil und dem oder den feststehenden Bauteilen vorgesehen ist,
wobei der Einsatz eine im Wesentlichen zylinderrohrartige From aufweist, so dass der Teil der Kathode, der drehbar und vakuumdicht in dem mindestens einem feststehenden Bauteil angeordnet ist, von dem Einsatz (1) umgeben ist, wobei sich die Gegenlauffläche (4) relativ zum Einsatz (I) dreht, wenn die Kathode rotiert, und wobei
Einsatz (1) und Gegenlauffläche (4) mindestens eine gegenseitig anliegende Dicht- und Lauffläche aufweisen, an der eine oder mehrere dynamische Dichtungen (3) vorgesehen sind, **dadurch gekennzeichnet, dass** der Einsatz als Isolator ausgeführt ist.

2. Kathodenanordnung nach Anspruch 1,
**dadurch gekennzeichnet, dass**
der Einsatz an der Seite, an der dynamische Dichtungen vorgesehen sind, mindestens einen umlaufenden Kanal (6) zur Überwachung der Dichtungen aufweist.

3. Kathodenanordnung nach Anspruch 1 oder 2
**dadurch gekennzeichnet, dass**
der Einsatz (I) aus Kunststoff, aus einem vakuumgeeigneten Kunststoff, aus Polyetheretherketon, Polyoxymethylen/Polyacetal oder Polyethylenterephthalat gefertigt ist.

4. Kathodenanordnung nach einem der vorhergehenden Ansprüche,
**dadurch gekennzeichnet, dass**
der Einsatz (1) drehfest an dem drehbaren Teil oder dem oder den feststehenden Bauteilen angeordnet ist.

5. Kathodenanordnung nach einem der vorhergehenden Ansprüche,
**dadurch gekennzeichnet, dass**
der Einsatz (1) mit einem flanschförmigen Ansatz an einem seiner Enden versehen ist.

6. Kathodenanordnung nach einem der vorhergehenden Ansprüche,
**dadurch gekennzeichnet, dass**
der Einsatz (1) mehrteilig ist.

7. Kathodenanordnung nach einem der vorhergehenden Ansprüche,
**dadurch gekennzeichnet, dass**
die Gegenlauffläche(4) und der Einsatz (1) und dazwischen angeordnete Dichtungen (3,5) mit ihren Gleit- und/oder Dichtflächen aufeinander angepasst sind, so dass eine Gleitung und Dichtung erzielt wird.

8. Kathodenanordnung nach einem der vorhergehenden Ansprüche,
**dadurch gekennzeichnet, dass**
die Gegenlauffläche (4) als separates Bauteil vorgesehen ist oder in dem drehbaren Teil oder dem oder den feststehenden Bauteilen integriert ist.

9. Kathodenanordnung nach einem der vorhergehenden Ansprüche,
**dadurch gekennzeichnet, dass**
der zylinderrohrartige Einsatz (1) Hauptseiten in Form von Innen- und Außenseiten aufweist, die im Wesentlichen parallel zur Drehachse verlaufen, wobei an einer der Hauptseiten des Einsatzes, die keine dynamischen Dichtungen aufweist, eine oder mehrere statische Dichtungen vorgesehen sind.

10. Kathodenanordnung nach einem der vorhergehenden Ansprüche,
**dadurch gekennzeichnet, dass**
der Einsatz (1) an der Seite, an der dynamische Dichtungen (3) vorgesehen sind, mindestens einen umlaufenden Kanal zur Einbringung von Schmiermittel aufweist.

11. Kathodenanordnung nach einem der vorhergehenden Ansprüche,
**dadurch gekennzeichnet, dass**
der zylinderrohrartige Einsatz (1) Hauptseiten in Form von Innen- und Außenseiten aufweist, die im Wesentlichen parallel zur Drehachse verlaufen, wobei eine dem oder den feststehenden Bauteilen zuweisende Seite des Einsatzes zumindest teilweise in radialer Richtung verläuft.

12. Kathodenanordnung nach einem der vorhergehenden Ansprüche,
**dadurch gekennzeichnet, dass**
die Gegenlauffläche (4) als separates Bauteil ausgebildet ist, dem eine oder mehrere statische Dichtungen zugeordnet sind.

13. Kathodenanordnung nach einem der vorhergehenden Ansprüche,
**dadurch gekennzeichnet, dass**
Dichtungen (2,3,5) vorgesehen sind, die gegen parallel und/oder quer zur Drehachse verlaufenden Dichtflächen wirken, wobei insbesondere statische Dichtungen zwischen Einsatz und feststehenden Bauteilen gegen quer zur Drehachse verlaufenden Dichtflächen vorgesehen sind.

14. Kathodenanordnung nach einem der vorhergehenden Ansprüche,
**dadurch gekennzeichnet, dass**
dynamische und statische Dichtungen (2,3,5) vorgesehen sind, die O-Ringe, X-Ringe und Dichtlippenkörper umfassen.

15. Kathodenanordnung nach einem der vorhergehenden Ansprüche,
**dadurch gekennzeichnet, dass**
Dichtungen (2,3,5) vorgesehen sind, die in Nuten des Einsatzes, der Gegenlauffläche, des oder der feststehenden Bauteile und/oder des drehbaren Teils aufgenommen sind.

16. Kathodenanordnung nach einem der vorhergehenden Ansprüche,
**dadurch gekennzeichnet, dass**
Dichtungen (2,3,5) vorgesehen sind, die insbesondere für dynamische Dichtungen Polytetrafluorethylen Graphit, Kohlefaser, Gummi oder sonstige Elastomere mit oder ohne Gleitbeschichtungen und Kombinationen davon umfassen.

17. Kathodenanordnung nach einem der vorhergehenden Ansprüche,
**dadurch gekennzeichnet, dass**
die Gegenlauffläche (4) an ihrer Lauffläche gehärteten Stahl, diamantartige Kohlenstoffschichten, Chromoxidschichten oder andere Gleitschichten umfasst.

## Claims

1. Cathode arrangement with a rotatable cathode, at least one stationary part, an insert (1) and a counter sliding surface (4), wherein at least one part of the cathode is arranged rotatably and vacuum tight in the at least one stationary part and the insert (1) is provided between the rotatable part and the stationary part(s),
wherein the insert has an essentially cylindrical shape, such that the part of the cathode which is arranged rotatably and vacuum tight in the at least one stationary part, is surrounded by the insert (1), wherein the counter sliding surface (4) rotates relative to the insert (1) when the cathode rotates, and wherein
insert (1) and counter sliding surface (4) have at least one mutually contiguous sealing and sliding surface at which are provided one or more dynamic seals (3),
**characterised by the fact that**
the insert is designed as an insulator.

2. Cathode arrangement of claim 1,
**characterised by the fact that**
at the side of the insert where dynamic seals are provided, the insert has at least one peripheral channel (6) for monitoring the seals.

3. Cathode arrangement in accordance with claims 1 or 2, **characterised by the fact that**
the insert (1) is made of polymer, a vacuum-suitable polymer, of polyether ether ketone, polyoxymethylene/polyacetal or polyethylene terephthalate.

4. Cathode arrangement in accordance with any of the previous claims,
**characterised by the fact that**
the insert (1) is arranged in a rotatably fixed manner at the rotatable part or the stationary part(s).

5. Cathode arrangement in accordance with any of the previous claims,
**characterised by the fact that**
the insert (1) comprises a flange-shaped appendage at one of its ends.

6. Cathode arrangement in accordance with any of the previous claims,
**characterised by the fact that**
the insert (1) is composed of several parts.

7. Cathode arrangement in accordance with any of the previous claims,
**characterised by the fact that**
the counter sliding surface (4) and the insert (1) and seals (3, 5) with their sliding and/or sealing surfaces arranged between them are adapted to each other, such that sliding and sealing are obtained.

8. Cathode arrangement in accordance with any of the previous claims,
**characterised by the fact that**
the counter sliding surface (4) is provided as a separate part or is integrated into the rotatable part or the stationary part(s).

9. Cathode arrangement in accordance with any of the previous claims,
**characterised by the fact that**
the cylindrical insert (1) has principal sides in the form of internal sides and external sides, which are essentially parallel to the axis of rotation, with one or more static seals provided at one of the main sides of the insert that has no dynamic seals.

10. Cathode arrangement in accordance with any of the previous claims,
**characterised by the fact that**
at that side of the insert (1) where dynamic seals (3) are provided, the insert (1) has at least one circumferential channel (6) for introducing lubricant.

11. Cathode arrangement in accordance with any of the previous claims,
**characterised by the fact**
that the cylindrical insert (1) has principal sides in the form of internal sides and external sides, which are extended essentially parallel to the axis of rotation, wherein preferably one side of the insert which is facing the fixed part(s) extends at least partly in the radial direction.

12. Cathode arrangement in accordance with any of the previous claims,
**characterised by the fact that**
the counter sliding surface (4) is formed as a separate part, to which one or more static seals are assigned.

13. Cathode arrangement in accordance with any of the previous claims,
**characterised by the fact that**
seals (2, 3, 5) are provided, which act on sealing surfaces extending parallel and/or transverse to the axis of rotation, wherein especially static seals between insert and fixed parts are provided for sealing surfaces running transverse to the axis of rotation.

14. Cathode arrangement in accordance with any of the previous claims,
**characterised by the fact that**
dynamic and static seals (2, 3, 5) are provided, comprising O-rings, X-rings, sealing lip bodies.

15. Cathode arrangement in accordance with any of the previous claims,
**characterised by the fact that**
seals (2, 3, 5) are provided, which are accommodated in grooves of the insert, of the counter sliding surface, of the fixed part(s) and/or of the rotatable part.

16. Cathode arrangement in accordance with any of the previous claims,
**characterised by the fact that**
seals (2, 3, 5) are provided, which, especially for dynamic seals, comprise polytetrafluoroethylene, graphite, carbon fibre, rubber or other elastomers with or without sliding coatings and combinations thereof.

17. Cathode arrangement in accordance with any of the previous claims,
**characterised by the fact that**
the sliding surface of the counter sliding surface (4) comprises hardened steel, diamond-like carbon layers, chrome oxide layers or other sliding layers.

## Revendications

1. Dispositif de cathode avec une cathode rotative, au moins un composant fixe, un insert (1) et une surface de rotation antagoniste (4), au moins une partie de la cathode étant rotative et placée étanche au vide dans le composant fixe qui existe au moins et l'insert (1) étant prévu entre la partie rotative et le ou les composants fixes,
l'insert présentant une forme substantiellement de type tube de cylindre si bien que la partie de la cathode qui est rotative et placée étanche au vide dans le composant fixe qui existe au moins est entourée par l'insert (1), la surface de rotation antagoniste (4) étant en rotation par rapport à l'insert (1) lorsque la cathode tourne et l'insert (1) et la surface de rotation antagoniste (4) présentant au moins une surface d'étanchéité et de rotation réciproquement adjacente sur laquelle une ou plusieurs étanchéités dynamiques (3) sont prévues,
**caractérisé en ce**
**que** l'insert est configuré comme isolant.

2. Dispositif de cathode selon la revendication 1,
**caractérisé en ce**
**que** l'insert présente au moins un canal périphérique (6) pour le contrôle des étanchéités sur le côté sur lequel des étanchéités dynamiques sont prévues.

3. Dispositif de cathode selon la revendication 1 ou 2,
**caractérisé en ce**
**que** l'insert (1) est fabriqué en matière plastique, en une matière plastique appropriée pour le vide, en polyétheréthercétone, en polyoxyméthylène/polyacétal ou en polyétherphtalate d'éthylène.

4. Dispositif de cathode selon l'une des revendications précédentes,
**caractérisé en ce**
**que** l'insert (1) est placé résistant à la rotation sur la partie rotative ou sur le ou les composants fixes.

5. Dispositif de cathode selon l'une des revendications précédentes,
**caractérisé en ce**
**que** l'insert (1) est pourvu d'un épaulement en forme de bride à l'une de ses extrémités.

6. Dispositif de cathode selon l'une des revendications précédentes,
**caractérisé en ce**
**que** l'insert (1) est en plusieurs parties.

7. Dispositif de cathode selon l'une des revendications précédentes,
**caractérisé en ce**
**que** la surface de rotation antagoniste (4) et l'insert (1) et les étanchéités placées entre eux (3, 5) sont adaptés l'un à l'autre avec leurs surfaces de glissement et/ou d'étanchéité de manière à obtenir un glissement et une étanchéité.

8. Dispositif de cathode selon l'une des revendications précédentes,
**caractérisé en ce**
**que** la surface de rotation antagoniste (4) est prévue comme composant séparé ou est intégrée dans la partie rotative ou le ou les composants fixes.

9. Dispositif de cathode selon l'une des revendications précédentes,
**caractérisé en ce**
**que** l'insert de type tube de cylindre (1) présente des côtés principaux en forme de côtés intérieurs et extérieurs qui sont substantiellement parallèles à l'axe de rotation, une ou plusieurs étanchéités statiques étant prévues sur l'un des côtés principaux de l'insert qui ne présente pas d'étanchéités dynamiques.

10. Dispositif de cathode selon l'une des revendications précédentes,
**caractérisé en ce**
**que** l'insert (1) présente au moins un canal périphérique pour introduire des lubrifiants sur le côté sur lequel des étanchéités dynamiques (3) sont prévues.

11. Dispositif de cathode selon l'une des revendications précédentes,
**caractérisé en ce**
**que** l'insert de type tube de cylindre (1) présente des côtés principaux en forme de côtés intérieurs et extérieurs qui sont substantiellement parallèles à l'axe de rotation, un côté de l'insert qui est tourné vers le ou les composants fixes étant au moins partiellement dans le sens radial.

12. Dispositif de cathode selon l'une des revendications précédentes,
**caractérisé en ce**
**que** la surface de rotation antagoniste (4) est configurée comme composant séparé auquel correspondent une ou plusieurs étanchéités statiques.

13. Dispositif de cathode selon l'une des revendications précédentes,
**caractérisé en ce**
**que** des étanchéités (2, 3, 5) sont prévues qui agissent contre des surfaces d'étanchéité qui sont parallèles et/ou transversales par rapport à l'axe de rotation, cependant que des étanchéités en particulier statiques sont prévues entre l'insert et les composants fixes contre des surfaces d'étanchéité qui sont transversales par rapport à l'axe de rotation.

14. Dispositif de cathode selon l'une des revendications précédentes,
**caractérisé en ce**
**que** des étanchéités dynamiques et statiques (2, 3, 5) sont prévues qui comprennent des joints toriques, des étanchéités en X et des corps à lèvres d'étanchéité.

15. Dispositif de cathode selon l'une des revendications précédentes,
**caractérisé en ce**
**que** des étanchéités (2, 3, 5) sont prévues qui sont logées dans des rainures de l'insert, de la surface de rotation antagoniste du ou des composants fixes et/ou de la partie rotative.

16. Dispositif de cathode selon l'une des revendications précédentes,
**caractérisé en ce**
**que** des étanchéités (2, 3, 5) sont prévues qui comprennent, en particulier pour des étanchéités dynamiques, du polytétrafluoréthylène, du graphite, des fibres de carbone, du caoutchouc ou d'autres élastomères avec ou sans enductions glissantes et des combinaisons de ceux-ci.

17. Dispositif de cathode selon l'une des revendications précédentes,
**caractérisé en ce**
**que** la surface de rotation antagoniste (4) comprend, sur sa surface de rotation, de l'acier trempé, des couches de carbone de type diamant, des couches d'oxyde de chrome ou d'autres couches de glissement.
